**Europäisches Patentamt**

**European Patent Office**

**Office européen des brevets**

(19)

(11) Veröffentlichungsnummer: **0 093 947**
**B1**

(12) # EUROPÄISCHE PATENTSCHRIFT

(45) Veröffentlichungstag der Patentschrift:
**24.07.85**

(51) Int. Cl.⁴: **H 03 K 19/177**

(21) Anmeldenummer: **83104085.2**

(22) Anmeldetag: **26.04.83**

(54) **Programmierbare Logikanordnung.**

(30) Priorität: **27.04.82 DE 3215671**

(43) Veröffentlichungstag der Anmeldung:
**16.11.83 Patentblatt 83/46**

(45) Bekanntmachung des Hinweises auf die Patenterteilung:
**24.07.85 Patentblatt 85/30**

(84) Benannte Vertragsstaaten:
**FR GB NL**

(56) Entgegenhaltungen:
**DE - B - 2 446 654**

(73) Patentinhaber: **Siemens Aktiengesellschaft, Berlin und München Wittelsbacherplatz 2, D-8000 München 2 (DE)**

(72) Erfinder: **Fuchs, Peter, Dipl.-Ing.,**
**Ludwig-Braille-Strasse 1, D-8000 München 70 (DE)**
Erfinder: **Müller-Glaser, Klaus, Dr.-Ing.,**
**Josef-Doll-Strasse 10, D-8027 Neuried (DE)**
Erfinder: **Schütt, Dieter, Dr., Ernastrasse 35,**
**D-8000 München 82 (DE)**
Erfinder: **Wach, Wolfgang, Dipl.-Phys., Hirschplanallee 7,**
**D-8042 Oberschleissheim (DE)**

Beschreibung

Die Erfindung bezieht sich auf eine integrierte programmierbare Logikanordnung nach dem Oberbegriff des Patentanspruchs 1.

Logikanordnungen dieser Art sind, auch unter den Kurzbezeichnungen PLA bzw. FPLA, allgemein bekannt [„Der Elektroniker", Heft 3, 1981, S. 44 bis 48, „Valvo-Brief", 25.10.1976, S. 1 bis 3, „Electronic Design", 29 (1981), H.4, S. 121 bis 124]. Bei solchen Logikanordnungen schalten Eingangsstufen die ursprünglichen Eingangsvariablen in ihrer wahren und invertierten Form auf Steuerleitungen einer Produktmatrix durch. An einem Teil der Kreuzungsstellen der Steuerleitungen mit Produktleitungen der Matrix sind Halbleiterelemente angeordnet, mit deren Hilfe Signalpotentiale auf den Produktleitungen durch die Eingangsvariablen steuerbar sind. An anderen Kreuzungsstellen fehlen entsprechende Verknüpfungselemente oder sind unwirksam gemacht. Die Produktleitungen bilden die Eingangsleitungen für eine Summenmatrix, in der sie sich mit Summenleitungen kreuzen. Auch hier sind die Verknüpfungselemente im allgemeinen nur für einen Teil der Kreuzungsstellen wirksam. Die auf den Summeleitungen vorliegenden Signale werden in Ausgangstreibern verstärkt und gelegentlich invertiert.

Die logischen Funktionen der Produktmatrix und der Summenmatrix müssen aufeinander abgestimmt sein. Anstelle einer UND-Verknüpfung mit einer darauf folgenden ODER-Verknüpfung kann beispielsweise zweimal eine NOR-Verknüpfung gebildet werden [vgl. „Electronic Design", 29 (1981) 4, S. 121 bis 124].

Häufig werden bei der Herstellung von integrierten programmierbaren Logikanordnungen zunächst an allen Kreuzungspunkten der Matrizen Verknüpfungs- bzw. Koppelelemente angeordnet, die dann entsprechend der Programmiervorschrift durch nachträgliches Auftrennen geeigneter Verbindungen, z. B. durch Ausbrennen, teilweise unwirksam gemacht werden (fusible links).

Abhängig von der Grösse der beiden Matrizen einer programmierbaren Logikanordnung lässt sich eine mehr oder weniger grosse Vielfalt von komplexen logischen Funktionen realisieren, die in ihrer Art durch die Progammierung bestimmt sind.

Vor allem in sequentiellen Schaltungen, bei denen die Summenleitungen beispielsweise mit den Dateneingängen von D-Flipflops verbunden sind, ist es häufig wünschenswert, in die Flipflop unabhängig von den an den Eingängen der Logikanordnung anliegenden Variablen ein externes Datum zu laden. Eine solche Möglichkeit bietet auch Vorteile für das Testen der sequentiellen Schaltungen.

Derartige Erweiterungen waren bisher nur durch einen hohen zusätzlichen Flächenaufwand für die Matrizen oder durch zusätzliche externe Schaltelemente möglich. Der Erfindung liegt die Aufgabe zugrunde, eine funktionale Erweiterung zu schaffen, die nur einen geringen Mehraufwand erfordert und die sich in die für die Integration erforderlichen regulären Strukturen einfügt. Gemäss der Erfindung wird diese Aufgabe mit Hilfe der Merkmale im kennzeichnenden Teil des Patentanspruchs 1 gelöst.

Im folgenden wird die Erfindung anhand von Ausführungsbeispielen, die in der Zeichnung dargestellt sind, näher beschrieben. Es zeigt:

Fig. 1 eine programmierbare Logikanordnung gemäss der Erfidung mit MOS-Transistoren,

Fig. 2 eine Logikanordnung mit bipolaren Transistoren.

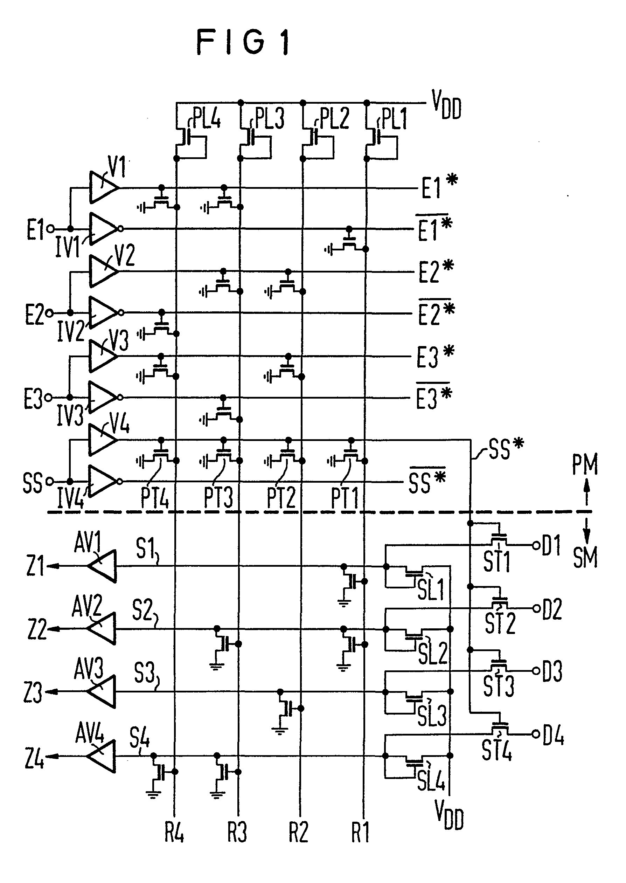

Die Fig. 1 zeigt die Schaltung einer progammierbaren Logikanordnung in N-MOS-Technologie mit willkürlich vorgegebener Progammierung. Die Produktmatrix PM ist für drei Eingangsvariable E1, E2 und E3 ausgelegt. Jeder der gleichnamigen Eingänge führt in einen invertierenden und in einen nichtinvertierenden Verstärker IV1 bis IV3 bzw. V1 bis V3, an deren Ausgänge die in der Zeichnung waagrecht verlaufenden Steuerleitungen E1* und $\overline{E1}$* bis E3* und $\overline{E3}$* zur Ansteuerung von Transistoren angeschlossen sind, die gemäss der Programmiervorschrift auf die Kreuzungspunkte mit vier senkrechten Produktleitungen R1 bis R4 verteilt sind. Die Transistoren legen entsprechend ihrer räumlichen Verteilung im leitenden Zustand Produktleitungen an das Nullpotential. Produktleitungen, die nicht mit leitenden Transistoren verbunden sind, nehmen mindestens annähernd das Versorgungspotential $V_{DD}$ an, das über Lasttransistoren PL1 bis PL4 vom Verarmungstyp zugeführt wird.

Die Produktleitungen R1 bis R4 bilden die Eingangsleitungen für die Summenmatrix SM, die ähnlich wie die Produktmatrix PM gebaut ist. An die Stelle der Produktleitungen R1 bis R4 in der Produktmatrix treten in der Summenmatrix die Summenleitungen S1 bis S4, die über weitere Lasttransistoren SL1 bis SL4 mit dem Versorgungspotential $V_{DD}$ verbunden sind. Ausgangsseitig führen die Summenleitungen zu Verstärkern AV1 bis AV4. Nach Verstärkung stehen an den Ausgangsklemmen Z1 bis Z4 die Verknüpfungsergebnisse der Logikanordnung als gleichnamige Ausgangssignale zur Verfügung.

Der bisher beschriebene Teil der Logikanordnung nach Fig. 1 entspricht bekannten Ausführungen. Gemäss der Erfindung ist zusätzlich ein Eingang SS für ein gleichnamiges Steuersignal vorgesehen, das über einen nichtinvertierenden Verstärker V4 und einen invertierenden Verstärker IV4 läuft. An die Ausgänge der beiden Verstärker V4 und IV4 sind zwei weitere Steuerleitungen SS* und $\overline{SS}$* der Produktmatrix PM angeschlossen. Wie aus Fig. 1 ersichtlich ist, könnte bei dem dargestellten Ausführungsbeispiel der invertierende Verstärker IV4 und die zugehörige Steuerleitung $\overline{SS}$* entfallen. An den Kreuzungsstellen der das nichtinvertierte Steuersignal SS* führenden Steuerleitung mit allen Produktleitungen R1 bis R4 sind Transistoren PT1 bis PT4 vorgesehen, die beim hohen binären Signalpegel des Steuersignals SS* die Produktleitungen R1 bis R4 an das Nullpotential legen. Damit bleiben unabhängig von den binären Werten der Eingangsvariablen E1 bis E3 alle Verknüpfungstransistoren der Summenmatrix SM gesperrt.

Die zuletzt genannte Steuerleitung SS* in der Produktmatrix ist zudem mit den Steuerelektroden weiterer Transistoren ST1 bis ST4 verbunden, deren gesteuerte Kanäle zwischen die Summenleitungen S1 bis S4 der Summenmatrix und zusätzliche Anschlusspunkte D1 bis D4 geschaltet sind. Die Transistoren ST1 bis ST4 werden im folgenden als Transferglieder bezeichnet. Beim hohen binären Pegel des Steuersignals SS* greifen also an den Anschlusspunkten D1 bis D4 anliegende Datensignale unmittelbar auf die Summenleitungen S1 bis S4 der Summenmatrix und damit auf die Ausgänge Z1 bis Z4 der Logikanordnung durch.

Von den Transistoren PT1 bis PT4 in der Produktmatrix PM können auch einzelne entfallen bzw. es können trennbare Verbindungen aufgetrennt werden, so dass die Potentiale der entsprechenden Produktleitungen nicht vom Steuersignal SS bzw. SS* beeinflusst werden. Dabei ist jedoch darauf zu achten, welche Summenleitungen S1 bis S4 mit der betroffenen Produktleitung oder den betroffenen Produktleitungen verkoppelt sind. Die solchen Summenleitungen zugeordneten Transferglieder für die unmittelbare Einspeisung von Datensignalen müssen dann entfallen oder die betreffenden Eingänge dürfen nicht beschaltet werden.

Würde beispielsweise in dem in Fig. 1 dargestellten Ausführungsbeispiel der Transistor PT1 in der Produktmatrix PM wegfallen, dass wären auch die Transferglieder ST1 und ST2 überflüssig (PT1→ST1, ST2, entsprechend gilt PT2→ST3, PT3→ST2, ST4 und PT4→ST4).

Da die Funktion der durch die MOS-Transistoren ST1 bis ST4 gebildeten Transferglieder von der Stromrichtung unabhängig ist, können die Auschlusspunkte D1 bis D4 auch als Signalausgänge für die Überwachung der Vorgänge auf den Summenleitungen dienen. Dies ist dann sehr vorteilhaft, wenn die Ausgänge Z1 bis Z4 als Punkte innerhalb einer integrierten Anordnung nicht oder nur schwer zugänglich sind oder wenn sie nicht ständig durch zusätzliche Anschlussleitungen belastet werden sollen.

Zu diesem Zweck ist es notwendig, die bisher einzige Steuerleitung für die Transistoren PT1 bis PT4 und ST1 bis ST4 (vergleich Fig. 1) in eine erste Steuerleitung SS1* für die Transistoren PT1 bis PT4 der Produktmatrix PM und in eine zweite Steuerleitung SS2* für die Transistoren bzw. Transferglieder ST1 bis ST4 der Summenmatrix SM aufzutrennen und für beide Steuerleitungen unabhängige Steuersignale SS1 und SS2 vorzusehen. Für das Testen der normalen Verknüpfungsfunktionen der Logikanordnung über die Anschlusspunkte D1 bis D4 muss dann für die Signale auf den Steuerleitungen gelten SS1* = L, SS2* = H, wobei L für den niederen und H für den hohen binären Signalpegel der Steuersignale gesetzt ist. Für die an den entsprechenden Steuereingängen anliegenden Steuersignale ergibt sich gleichfalls SS1 = L, SS2 = H, wenn die zwischen den Steuereingängen und den Steuerleitungen angeordneten Verstärker nicht invertieren.

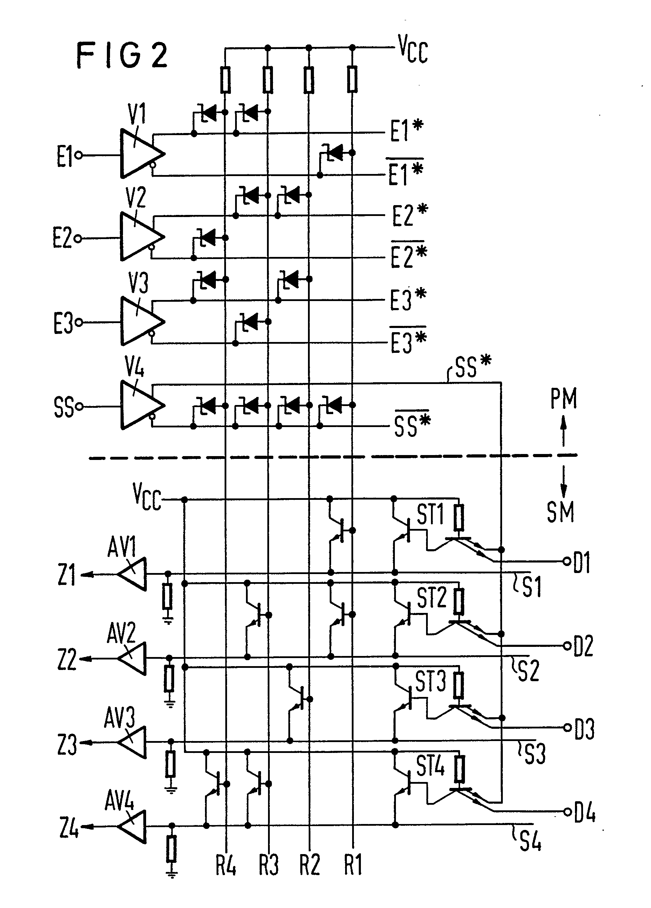

Die Erweiterung einer programmierbaren Logikanordnung gemäss der Erfindung kann auch vorgenommen werden, wenn die Logikanordnung in Bipolartechnik ausgebildet ist. Ein vereinfachtes Ausführungsbeispiel hierzu zeigt die Fig. 2. Die Programmierung der Logikanordnung, d. h. die Verteilung der Verknüpfungselemente in den beiden Matrizen ist wieder willkürlich gewählt. Als Verknüpfungselemente in der Produktmatrix sind Schottkydioden und in der Summenmatrix Transistoren in Emitterfolgerschaltung vorgesehen. Dies ist jedoch keine notwendige Bedingung.

Zur Sperrung der Produktmatrix dienen ebenfalls Schottkydioden, die einerseits an die Produktleitungen und andererseits an den invertierenden Ausgang des Verstärkers V4 für das Steuersignal SS angeschlossen sind.

Die Transferglieder ST1 bis ST4 sind als UND-Glieder nach Art von TTL-Schaltungen ausgebildet mit dem Unterschied, dass die im Sinne des Signalflusses jeweils zweiten Transistoren als Emitterfolger geschaltet sind. Die jeweils ersten Transistoren weisen zwei Emitter auf, von denen die einen gemeinsam mit dem nichtinvertierenden Ausgang des Verstärkers V4 und die anderen mit den Anschlusspunkten D1 bis D4 verbunden sind. Es ist klar, dass die Anschlusspunkte D1 bis D4 in diesem Fall nur als Dateneingänge dienen können.

Durch die Hintereinanderschaltung von zwei oder mehreren erweiterten Logikanordnungen kann eine Vielzahl von neuen Funktionen realisiert werden, von denen hier nur zwei unter Beschränkung auf die Hintereinanderschaltung von zwei Logikanordnungen erwähnt werden.

Durch Verbinden der Ausgäng $Z_{i1}$ der ersten Logikanordnung PLA mit den Dateneingängen $D_{i2}$ der zweiten Logikanordnung PLA2 ohne Vertauschung erhält man abhängig von dem Steuersignal SS der zweiten Logikanordnung an den Ausgängen $Z_{i2}$ entweder die der ersten oder der zweiten Logikanordnung entsprechend der jeweiligen Programmierung immanenten Verknüpfungsergebnisse. Dabei können die an den variablen Eingängen $E_{k1}$ und $E_{k2}$ anliegenden Variablen gleich, teilweise verschieden oder ganz verschieden sein.

Eine weitere Möglichkeit besteht darin, die Ausgänge $Z_{i1}$ einer ersten Logikanordnung sowohl mit den Variableneingängen $E_{k2}$ als auch mit den Dateneingängen $D_{i2}$ der zweiten Logikanordnung in beliebiger Vertauschung zu verbinden. Daraus ergibt sich eine mit Hilfe des Steuersignals SS der zweiten Logikanordnung wählbare Verschlüsselung der ursprünglichen Verknüpfungsfunktionen.

**Patentansprüche**

1. Programmierbare Logikanordnung mit einer Produktmatrix (PM), bei der Steuerleitungen (E1*-E3*, $\overline{E1*}$-$\overline{3*}$) für wahre und invertierte Eingangsvariable mit Hilfe von durch die Eingangsvariablen (E1-E3) gesteuerten Halbleiter-Verknüpfungselementen gemäss einer Programmierungsvorschrift mit Produktleitungen (R1-R4) zur Bildung von Produktsignalen derart verknüpft sind, dass bestimmte Eingangsvariable auf Produktleitungen den höheren oder den tieferen von zwei binären Signalpegeln erzeugen oder Produktleitungen gar nicht beeinflussen, mit einer Summenmatrix (SM), bei der die Produktleitungen mit Hilfe von durch die Produktsignale gesteuerten Halbleiter-Verknüpfungselementen gemäss einer weiteren Programmierungsvorschrift mit Summenleitungen (S1-S4) zur Bildung von Summensignalen derart verknüpft sind, dass bestimmte Produktsignale auf Summenleitungen den höheren oder tieferen binären Signalpegel erzeugen oder Summenleitungen gar nicht beeinflussen, dadurch gekennzeichnet, dass eine mit einem ersten Steuersignal beaufschlagte Steuerleitung vorgesehen ist, die mit Hilfe von durch das Steuersignal gesteuerten Halbleiter-Verknüpfungselementen (PT1 bis PT4) mit mindestens einem Teil der Produktleitungen (R1 bis R4) verknüpfbar ist und dass über eine mit dem ersten oder mit einem zweiten Steuersignal beaufschlagte Steuerleitung Transferglieder (ST1 bis ST4) gesteuert werden, die in leitendem Zustand die Summenleitungen (S1 bis S4) mit weiteren Signalanschlüssen (D1 bis D4) verbinden.

2. Logikanordnung nach Anspruch 1, dadurch gekennzeichnet, dass die Halbleiter-Verknüpfungselemente und die Transferglieder (ST1 bis ST4) aus MOS-Transistoren bestehen.

3. Logikanordnung nach Anspruch 2, dadurch gekennzeichnet, dass das erste Steuersignal und das zweite Steuersignal voneinander unabhängige Signale sind.

4. Logikanordnung nach Anspruch 2, dadurch gekennzeichnet, dass das erste Steuersignal und das zweite Steuersignal identische Signale (SS) sind.

5. Logikanordnung nach Anspruch 1, dadurch gekennzeichnet, dass die Halbleiter-Verknüpfungselemente und die Transferglieder (ST1 bis ST4) aus bipolaren Transistoren bestehen.

6. Logikanordnung nach Anspruch 1, dadurch gekennzeichnet, dass die Halbleiter-Verknüpfungselemente der Produktmatrix (PM) aus Dioden und die Halbleiter-Verknüpfungselemente der Summenmatrix (SM) und die Transferglieder (ST1 bis ST4) aus bipolaren Transistoren bestehen.

7. Logikanordnung nach Anspruch 6, dadurch gekennzeichnet, dass das erste Steuersignal und das zweite Steuersignal zueinander inverse Signale sind.

## Claims

1. A programmable logic arrangement with a product matrix (PM) in which control lines (E1 *-E3 *, $\overline{E1}$ *-$\overline{E3}$*) for true and inverted input variables are logic-linked with the assistance of semiconductor logic-linking elements controlled by the input variables (E1-E3) in accordance with a programming rule to product lines (R1-R4) for the formation of product signals, in such manner that specific input variables produce the higher or the lower of two binary signal levels on product lines or have no influence on product lines, with a sum matrix (SM) in which the product lines are logic-linked with the assistance of semiconductor logic-linking elements controlled by the product signals in accordance with a further programming rule to sum lines (S1-S4) for the formation of sum signals, in such manner that specific product signals produce the higher or lower binary signal level on sum lines or have no influence on sum lines, characterised in that a control line is provided which is acted upon by a first control signal and which can be logic-linked with the assitance of semiconductor logic-linking elements (PT1 to PT4), controlled by the control signal, to at least one part of the product lines (R1 to R4), and that a control line which is acted upon by the first or a second control signal controls transfer elements (ST1 to ST4) which connect the sum lines (S1 to S4) to further signal terminals (D1 to D4) when in the conductive state.

2. A logic arrangement as claimed in Claim 1, characterised in that the semiconductor logic-linking elements and the transfer elements (ST1 to ST4) consist of MOS-transistors.

3. A logic arrangement as claimed in Claim 2, characterised in that the first control signal and the second control signal are mutually independent signals.

4. A logic arrangement as claimed in Claim 2, characterised in that the first control signal and the second control signal are identical signals (SS).

5. A logic arrangement as claimed in Claim 1, characterised in that the semiconductor logic-linking elements and the transfer elements (ST1 to ST4) consist of bipolar transistors.

6. A logic arrangement as claimed in Claim 6, characterised in that the semiconductor logic-linking elements of the product matrix (PM) consist of diodes and the semiconductor logic-linking elements of the sum matrix (SM) and the transfer elements (ST1 to ST4) consist of bipolar transistors.

7. A logic arrangement as claimed in Claim 6, characterised in that the first control signal and the second control signal are mutually inverse signals.

## Revendications

1. Dispositif logique programmable avec une matrice-produit (PM), dans lequel des conducteurs de commande (E1 *-E3 *, $\overline{E1}$ *-$\overline{E3}$*) pour des variables d'entrée réelles et inversées sont combinés de telle manière, à l'aide d'éléments combinatoires à semi-conducteurs commandés par des variables d'entrée (E1-E3) et selon un protocole de programmation, avec des conducteurs-produits (R1-R4) pour former des signaux-produits, que certaines variables d'entrée produisent sur des conducteurs-produits le plus haut ou le plus bas de deux niveaux de signaux binaires, ou n'influencent pas du tout des conducteurs-produits, et comportant une matrice-somme (SM) dans laquelle les conducteurs-produits sont combinés à l'aide d'éléments combinatoires à semi-conducteurs, commandés par les signaux-produits et selon un second protocole de programmation, avec les conducteurs-sommes (S1, S4) de telle manière, pour former des signaux-sommes, que certains signaux-produits produisent sur les conducteurs-sommes le niveau de signaux binaires le plus haut ou le plus bas, ou n'influencent pas du tout des conducteurs-sommes, caractérisé par le fait qu'il est prévu un conducteur de commande chargé par un premier signal de commande et suspceptible d'être combiné, par l'intermédiaire d'éléments combinatoires à semi-conducteurs (PT1 à PT4) commandés par le signal de commande, avec au moins une partie des conducteurs-produits (R1 à R4), et que par l'intermédiaire d'un conducteur de commande chargé avec le premier ou le second signal de commande sont commandés des éléments de transfert (ST1 à ST4) qui relient, lorsqu'ils sont dans leur état passant, les conducteurs-sommes (S1 à S4) avec d'autres bornes de signaux (D1 à D4).

2. Dispositif logique selon la revendication 1, caractérisé par le fait que les éléments combinatoires à semi-conducteurs et les éléments de transfert (ST1 à ST4) sont constitués par des transistors MOS.

3. Dispositif logique selon la revendication 2, caractérisé par le fait que le premier signal de commande et le second signal de commande sont des signaux qui sont indépendants l'un de l'autre.

4. Dispositif logique selon la revendication 2, caractérisé par le fait que le premier signal de commande et le second signal de commande sont des signaux identiques (SS).

5. Dispositif logique selon la revendication 1, caractérisé par le fait que les éléments combinatoires à semi-conducteurs et les éléments de transfert (ST1 à ST4) sont constitués par des transistors bipolaires.

6. Dispositif logique selon la revendication 1, caractérisé par le fait que les éléments combinatoires à semi-conducteurs de la matrice-produit (PM) sont constitués par des diodes, et les éléments combinatoires à semi-conducteurs de la matrice-somme (SM) et les éléments de transfert (ST1 à ST4) sont constitués par des transistors bipolaires.

7. Dispositif logique selon la revendication 6, caractérisé par le fait que le premier signal de commande et le second signal de commande sont des signaux inverses l'un par rapport à l'autre.

**0 093 947**

# F I G 1

FIG 2

0 093 947